# EUROPEAN PATENT SPECIFICATION

(11) **EP 3 460 494 B1**
(45) Date of publication and mention of the grant of the patent: **25.01.2023**
(21) Application number: 17193123.1
(22) Date of filing: 26.09.2017
(51) Int. Cl.: G01R 31/08, H02H 3/04, H02H 1/00, G06N 3/04, G06N 3/08, G01R 31/52

(54) **A METHOD AND APPARATUS FOR AUTOMATIC DETECTION OF A FAULT TYPE**
VERFAHREN UND VORRICHTUNG ZUM AUTOMATISCHEN BESTIMMEN EINER FEHLERART
PROCÉDÉ ET APPAREIL DE DÉTECTION AUTOMATIQUE D'UN TYPE DE DÉFAUT

(43) Date of publication of application: 27.03.2019
(73) Proprietor: Siemens Aktiengesellschaft, 80333 München (DE)
(72) Inventor: Büttner, Florian, 81541 München (DE); Buggenthin, Felix, 81373 München (DE); Spieckermann, Sigurd, 85591 Vaterstetten (DE); Becher, Silvio, 81827 München (DE); Böhme, Klaus, 12305 Berlin (DE); Kereit, Matthias, 12159 Berlin (DE); Kogan, Igor, 10719 Berlin (DE)

(56) References cited:
- DE-A1- 4 333 260
- DE-C1- 4 433 406
- M. Kezunovic ET AL: "Detect and classify faults using neural nets", , 1 October 1996 (1996-10-01), XP055454880, Retrieved from the Internet: URL:http://dx.doi.org/10.1109/67.539846 [retrieved on 2018-02-27]
- SANAYE-PASAND M ET AL: "High Speed Transmission System Directional Protection using an Elman Network", IEEE TRANSACTIONS ON POWER DELIVERY, IEEE SERVICE CENTER, NEW YORK, NY, US, vol. 13, no. 4, 1 October 1998 (1998-10-01), pages 1040-1045, XP011049621, ISSN: 0885-8977, DOI: 10.1109/61.714443
- MAHANTY R N ET AL: "Application of RBF neural network to fault classification and location in transmission lines", IEE PROCEEDINGS: GENERATION, TRANSMISSION AND DISTRIBUT, INSTITUTION OF ELECTRICAL ENGINEERS, GB, vol. 151, no. 2, 2 March 2004 (2004-03-02) , pages 201-212, XP006021648, ISSN: 1350-2360, DOI: 10.1049/IP-GTD:20040098

## Description

The invention relates to a method and an apparatus for automatic detection of a fault type of a fault having occurred at power transmission lines of a power supply system.

A power supply system can comprise several power transmission lines. Most power supply systems comprise 3-phased power transmission lines L1, L2, L3. During the distribution of electrical power in a power transmission system via the power transmission lines unexpected failures can occur due to various causes. For example, one or more current loops can comprise a short circuit caused by a falling tree or branch during a storm. Further, a power transmission loop might be interrupted when lightning strikes a pole. As such failures impact a reliable and safe operation of the power supply system they need to be detected and measures have to be taken to prevent a propagation of faults to the remaining power supply grid.

In conventional power supply systems protective devices are installed at both ends of power transmission lines. These protective devices constantly monitor electrical currents and voltages of every power transmission line loop. When an error occurs, i.e. if the normal signal of a phased sine-wave is disturbed by any kind of anomaly, the protective device does trigger the generation of a fault record and shuts down the affected power transmission lines. Given the fault record that does contain the raw signals of every power transmission line in a given time interval it is possible to determine the specific type of the respective fault. In conventional power supply systems a classification of a fault type of fault having occurred at power transmission lines can be performed in two main steps. First, by extensive signal processing, the custom features characterizing the raw signals in the fault record are extracted. Based on these features a set of previously established rules is applied and the specific fault type is determined. Possible improvements of the fault classification module can only be carried out by adding new custom rules which involves a substantial manual expert-driven effort.

DE 44 33 406 C1 discloses a distance protection unit for an electrical power supply net with a neural net arrangement connected over current and voltage converter and an ADC. The distance protection unit further comprises a fault determination unit with a single neural net that is trained by simulated current and/or voltage faults, which can occur within different overload states in the electrical power supply net. This training results in a predefined behavior where an output signal is provided for an already known fault.

Document "Detect and Classify Faults Using Neural Nets" describes different approaches for fault analysis. One presented approach relates to a neural network implementation using defined detailed training data sets that represents cases the neural net needs to learn.

Document "High speed transmission system directional protection using an Elman network" relates detection of the direction of a fault on a transmission line, to classify forward and backward faults on a given line. Training patterns were generated by simulating different types of faults.

Document DE 43 33 260 A1 discloses an apparatus to generate a stimulate signal for a protection arrangement power supply net.

Document "Application of RBF neural network to fault classification and location in transmission lines" discloses a radial basis function (RBF) artificial neural network with two fault classifiers to detect faults involving earth and faults not involving earth.

Accordingly, it is an object of the present invention to provide a method and apparatus which provide a reliable and robust fault type detection and which require few storage and computation resources.

This object is achieved according to a first aspect of the present invention by an in-field detection apparatus comprising the features of claim 1.

The invention provides according to the first aspect an in-field detection apparatus for automatic detection of a fault type of a fault having occurred at power transmission lines of a power supply system,
said in-field detection apparatus comprising:
a preprocessing unit adapted to normalize measured voltage raw data and/or current raw data of the power transmission lines and
a processing unit configured to execute an artificial neural network stored in a local memory of said in-field detection apparatus,
wherein the normalized voltage and/or current raw data is mapped to fault type scores of different predefined fault types and wherein the fault type scores are evaluated by said processing unit to detect the fault type of the occurred fault, wherein the in-field detection apparatus further comprises an artificial intelligence module, wherein the artificial intelligence module and the artificial neural network is trained on a combination of simulated fault records and faults comprising real data samples of historical real faults, to interpret patterns in the data to process new previously unseen data samples or fault records.

In a possible embodiment of the in-field detection apparatus according to the first aspect of the present invention the artificial neural network stored in the local memory of said in-field detection apparatus comprises a feed-forward neural network.

In a further possible embodiment of the in-field detection apparatus according to the first aspect of the present invention the feed-forward neural network stored in the local memory of the in-field detection apparatus comprises a convolutional neural network.

In a still further possible embodiment of the in-field detection apparatus according to the first aspect of the present invention the artificial neural network stored in the local memory of the in-field detection apparatus comprises a recurrent neural network.

In a still further possible embodiment of the in-field detection apparatus according to the first aspect of the present invention the fault type detected by said in-field detection apparatus comprises a short circuit between power transmission lines and/or an interruption of a power transmission line.

In a still further possible embodiment of the in-field detection apparatus according to the first aspect of the present invention the preprocessing unit and the processing unit operate in real time to detect the fault type of the fault having occurred at a power transmission line of said power supply system.

In a still further possible embodiment of the in-field detection apparatus according to the first aspect of the present invention the artificial neural network executed by said processing unit comprises an input layer adapted to receive the normalized measured voltage and/or current raw data from said preprocessing unit, one or more hidden layers and an output layer adapted to output the fault type scores evaluated to detect the fault type of the occurred fault.

In a still further possible embodiment of the in-field detection apparatus according to the first aspect of the present invention the fault type scores comprise a probability that a fault of a predefined fault type has occurred.

In a still further possible embodiment of the in-field detection apparatus according to the first aspect of the present invention the preprocessing unit is adapted to normalize raw data of a measured fault record comprising voltage raw data of different voltage phases transported through corresponding power transmission lines,
current raw data of associated electrical currents transported through the respective power transmission lines and current raw data of an electrical current flowing through earth.

In a still further possible embodiment of the in-field detection apparatus according to the first aspect of the present invention the voltage and/or current raw data of the measured fault record processed by said preprocessing unit comprises data samples measured by corresponding sensors within a time window having a predetermined window size.

In a still further possible embodiment of the in-field detection apparatus according to the first aspect of the present invention a database or an online stream of fault records with known fault types is provided and used to train the artificial neural network stored in the local memory of said in-field detection apparatus.

In a still further possible embodiment of the in-field detection apparatus according to the first aspect of the present invention the database of fault records comprises simulated fault records and/or fault records of historical faults having occurred at power transmission lines of said power supply system.

In a still further possible embodiment of the in-field detection apparatus according to the first aspect of the present invention the preprocessing unit is adapted to perform a Z-score or min-max normalization of measured voltage and/or current raw data of power transmission lines.

In a still further possible embodiment of the in-field detection apparatus according to the first aspect of the present invention countermeasures to remove the fault are initiated automatically by a controller depending on the detected fault type.

In a still further possible embodiment of the in-field detection apparatus according to the first aspect of the present invention the local memory of said in-field detection apparatus comprises a small memory space of less than 256 Megabyte.

The invention provides according to a second aspect a method for automatic detection of a fault type comprising the features of claim 15.

The invention provides according to the second aspect a method for automatic detection of a fault type of a fault having occurred at power transmission lines of a power supply system,
the method comprising the steps of:
training an artificial intelligence module and an artificial neural network,
normalizing measured voltage raw data and/or current raw data of power transmission lines, executing the artificial neural network stored in a local memory of an in-field detection apparatus to map the normalized voltage and current raw data to fault type scores of different predefined fault types and
evaluating the fault type scores to detect the fault type of the occurred fault, wherein the artificial intelligence module and the artificial neural network are trained in the step of training on a combination of simulated fault records and faults comprising real data samples of historical real faults, to interpret patterns in the data to process new previously unseen data samples or fault records.

In the following possible exemplary embodiments of the different aspects of the present invention are described in more detail with reference to the enclosed figures.
- Fig. 1: shows a block diagram of a possible exemplary embodiment of an in-field detection apparatus according to the first aspect of the present invention.
- Fig. 2: shows a flowchart of a possible exemplary embodiment of a method for automatic detection of a fault type according to the second aspect of the present invention.

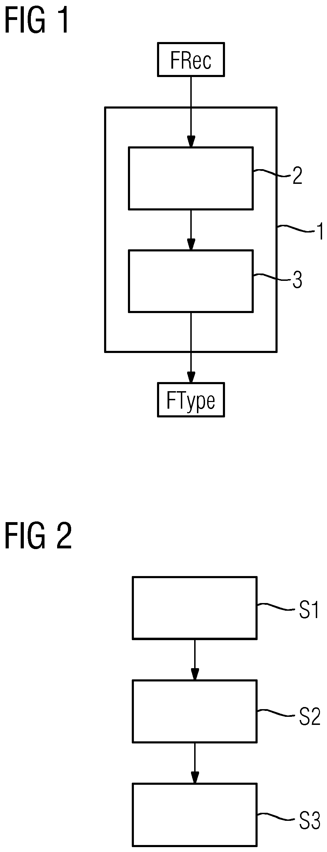

As can be seen in the block diagram of Fig. 1 an in-field detection apparatus 1 for automatic detection of a fault type according to the first aspect of the present invention comprises in the illustrated exemplary embodiment two main components, i.e. a preprocessing unit 2 and a processing unit 3. The in-field detection apparatus 1 can be provided for automatic detection of a fault type of a fault having occurred at power transmission lines of a power supply system. The in-field detection apparatus 1 as shown in Fig. 1 can be provided at a node of a power supply grid. Between the nodes of the power supply grid electric power transmission lines are provided for transporting electrical voltage and/or electrical currents. The power supply system can comprise in a possible embodiment three different phased power transmission lines L1, L2, L3. The preprocessing unit 2 receives a measured fault record including raw data. The raw data can comprise in a possible embodiment voltage raw data of different voltage phases transported through corresponding power transmission lines, current raw data of associated electrical currents transported through the respective power transmission lines and current raw data of an electric current flowing through earth. The preprocessing unit 2 is adapted to normalize the measured voltage raw data and/or current raw data of the power transmission lines as specified in the received fault record. The voltage and current raw data of the measured fault record processed by the preprocessing unit 2 can comprise data samples measured by corresponding sensors within a time window having a predetermined window size. In a possible embodiment the preprocessing unit 2 of the in-field detection apparatus 1 is adapted to perform a Z-score min-max normalization of the measured voltage and/or current raw data of the power transmission lines specified in the received fault records.

The in-field detection apparatus 1 further comprises a processing unit 3 connected to the preprocessing unit 2. The processing unit 3 is configured to execute an artificial neural network ANN stored in a local memory of the in-field detection apparatus 1. The normalized voltage and/or current raw data is mapped to fault type scores of different predetermined fault types. Further, the fault type scores are evaluated by the processing unit 3 to detect the fault type of the occurred fault. The detected fault type of the occurred fault can be output by the processing unit 3. The artificial neural network used by the processing unit 3 can be stored in a possible embodiment in a local memory of the in-field detection apparatus 1. The local memory can form part of the in-field detection apparatus 1 or can be connected directly to the in-field detection apparatus 1. The artificial neural network ANN can comprise in a possible embodiment a feed-forward neural network, in particular a convolutional neural network CNN. In an alternative embodiment the artificial neural network stored in the local memory of the in-field detection apparatus 1 can comprise a recurrent neural network RNN. A fault type detected by the in-field detection apparatus 1 can be a short circuit between at least two power transmission lines or an interruption of a power transmission line L. In a preferred embodiment the preprocessing unit 2 as well as the processing unit 3 operate in real time to detect the fault type of a fault having occurred at at least one power transmission line of the power supply system.

The artificial neural network ANN executed by the processing unit 3 comprises an input layer adapted to receive the normalized measured voltage and/or current raw data from the preprocessing unit 2. Further, the artificial neural network comprises one or more hidden layers and an output layer. The output layer is adapted to output the fault type scores which are evaluated to detect the fault type of the occurred fault. In a possible embodiment the fault type scores can comprise a probability that a fault of predefined fault type has occurred.

The artificial neural network ANN used by the processing unit 3 can be trained with a set of data. In a possible embodiment a database or an online stream of fault records with known fault types can be used to train the artificial neural network stored in the local memory of the in-field detection apparatus 1 and used by the processing unit 3 to detect the fault type of the occurred fault. In a possible embodiment the database of fault records used for training the artificial network can comprise simulated fault records and/or fault records of historical faults having occurred in power transmission lines of the power supply system in the past. In a further embodiment countermeasures to remove the detected fault can be initiated automatically by a controller depending on the detected fault type output by the processing unit 3 of the in-field detection apparatus 1. The artificial neural network ANN used by the processing unit 3 of the in-field apparatus 1 requires low storage resources. In a possible embodiment the local memory of the in-field detection apparatus 1 used for storing the artificial neural network ANN can comprise a small memory space of less than 256 Megabytes.

The in-field detection apparatus 1 employs an artificial intelligence module to detect a number and identity of current loops of power transmission lines affected by an incident based on the received fault record. Any combination of loops (L1, L2, L3) and earth (E) can be affected by any given incident. The artificial intelligence module with the artificial neural network ANN can be trained in a possible embodiment on a combination of synthetic fault records that can be efficiently generated by existing simulation systems. Further, the fault records can also comprise real data samples of historical faults having occurred in the past. In this way the artificial neural network ANN learns to interpret patterns in the data which can be used to also process new previously unseen data samples or fault records. The artificial neural network ANN executed by the processing unit 3 comprises a higher performance than conventional rule-based systems. The performance of the artificial neural network ANN can be further improved by retraining it on a larger set of fault records with a minimal effort and can be implemented or deployed on extremely resource-limited devices. In a possible embodiment the data normalized by the preprocessing unit 2 can be passed through a network of weighted linear or non-linear functions which results in a set of values indicating a fault type wherein each detected fault type can be mapped to a specific combination of affected loops within the power transmission system. In a possible embodiment the artificial neural network ANN comprises at least one convolutional layer consisting of a number of local filters automatically extracting meaningful features from the input signals, followed by at least one fully connected layer connecting the flattened filter signals to a number of output nodes equaling the number of fault types. In a possible embodiment each output node of the output layer can correspond to a single specific fault type (e.g. L1, L1-L2, L1-L3, L2-L3, ..., L1-L2-L3-E) and the final fault type can be identified by selecting the output node with the maximum value associated. The weights of the artificial neural network ANN can be trained by sequentially passing data samples with a known fault type through the artificial neural network ANN and by comparing the generated output values with the occurred fault.

The in-field detection apparatus 1 can use the artificial neural network ANN stored in a local memory as a fault classifier. The in-field detection apparatus comprising the preprocessing unit 2 and the processing unit 3 can be embedded in different kinds of in-field protection devices such as SIPROTEC having very limited computational and storage resources. The preprocessing and processing unit of the in-field detection apparatus 1 as illustrated in Fig. 1 requires very few storage resources and low computational resources. In a possible embodiment the number of weights in the artificial neural network ANN can be limited to further safe resources.

Fig. 2 shows a flowchart of a possible exemplary embodiment of a method for automatic detection of a fault type or a fault having occurred at power transmission lines of a power supply system according to the second aspect of the present invention.

In the illustrated exemplary embodiment the method comprises three main steps.

In first step S1 the measured voltage raw data and/or current raw data of the power transmission lines of the power supply system are normalized. This normalization can comprise a Z-score or min-max normalization of the measured voltage and/or current raw data.

In a further step S2 an artificial neural network ANN stored in a local memory of the in-field detection apparatus 1 is executed to map the normalized voltage and current raw data to fault type scores of different predefined fault types.

In a third step S3 the fault type scores are evaluated to detect the fault type of the occurred fault. The detected fault type can then be output via a user interface and/or data interface of the in-field detection apparatus 1 or for further processing and/or for triggering an automatic countermeasure to remove the detected fault type with the specific detected fault type.

The artificial neural network ANN used in step S2 can be trained in a training procedure before initiating step S1. In a possible embodiment a database or an online stream of fault records with known fault types can be generated by existing simulation algorithms, while generalization capabilities of the module can depend on the number and variation of fault records it is trained on. The performance of the artificial neural network ANN can be increased by adding as many real fault records to the training data set as possible. In a possible embodiment the data set can be split into a training data set and a validation data set. The artificial neural network ANN can then be optimized on the training data and tested on the validation data set which is not used during training. Once training of the artificial neural network ANN has been completed, (i.e. the error has been minimized) the artificial neural network can be stored in the local memory of the in-field detection apparatus 1 for operation in the system. In a possible embodiment new data samples, i.e. a fault record can be passed through the artificial neural network ANN without knowing the intended output value. Thus, only a forward pass is required without back-propagating any error. In a possible embodiment the artificial neural network can be trained until the categorical cross entropy between the predicted function samples and real ones is minimized. The method and apparatus according to the present invention do not require any feature computation on the raw input signals as the artificial neural network ANN is capable of learning important characteristics directly in an end-to-end fashion. A conventional feature-based approach requires an extensive amount of domain understanding and manual effort to design good specific features which also bears a risk of missing important patterns that cannot be recognized in the defined feature set. The performance of the method and apparatus according to the present invention relies on the raw input data with a normalization step and can consequently easily be extended or improved by feeding additional simulated fault records or real fault records to the artificial neural network. The method and apparatus according to the present invention is data-driven. Consequently the artificial neural network ANN is continuously improved with more data or fault records. The method and apparatus according to the present invention is not rule-based and can therefore be more easily adapted to the respective use case without extensive of expert domain knowledge. The apparatus and method can be trained on simulated or real fault data. The method and apparatus do not require to compute domain-specific features as the features can be implicitly learned by the artificial neural network ANN. In a preferred embodiment the artificial neural network ANN used by the method and apparatus according to the present invention comprises a deep neural network in particular a convolutional deep neural network. A further advantage of the method and apparatus according to the present invention is that new and improved versions of the artificial intelligence module can be generated autonomously, i.e. it is possible to retrain the module or artificial neural network on new/more data without any human interaction.

In a possible embodiment of the method and apparatus according to the present invention the detected fault types can be output via an interface to a controller of the power supply system. The controller can evaluate the received fault type and trigger automatic countermeasures and/or inform a user via a user interface. In a possible embodiment countermeasures comprise an automatic shutdown of affected power transmission lines depending on the detected fault type. In a further embodiment the controller of the system can activate a switching actuator via a control signal depending on the detected fault type of the occurred fault. In a possible embodiment the in-field detection apparatus can receive raw signals from every power transmission line in a given time interval of e.g. less than 20 ms. The method and apparatus according to the present invention operate in a preferred embodiment in real time so that countermeasures can be initiated or triggered very fast depending on the detected fault type. In a possible embodiment the method requires a very low computation time to detect the fault type comprising less than 200 ms. The artificial neural network ANN has a very small memory footprint and can be stored for instance in a small memory having a memory size of less than 256 Megabytes. Accordingly, the method and apparatus according to the present invention can be implemented on any kind of in-field detection apparatus even if this apparatus comprises only a small data memory and/or limited computation resources. In a possible embodiment the in-field detection apparatus 1 can be implemented on a SIPROTEC device of an electrical power supply system.

## Claims

1. An in-field detection apparatus (1) for automatic detection of a fault type of a fault having occurred at power transmission lines of a power supply system,
said in-field detection apparatus (1) comprising:
(a) a preprocessing unit (2) adapted to normalize measured voltage raw data and/or current raw data of the power transmission lines;
(b) a processing unit (3) configured to execute an artificial neural network, ANN, stored in a local memory of said in-field detection apparatus, wherein the normalized voltage and/or current raw data is mapped to fault type scores of different predefined fault types and wherein the fault type scores are evaluated by said processing unit (3) to detect the fault type of the occurred fault;
wherein the in-field detection apparatus (1) is **characterized by**
(c) an artificial intelligence module, wherein the artificial intelligence module and the artificial neural network is trained on a combination of simulated fault records and faults comprising real data samples of historical real faults, to interpret patterns in the data to process new previously unseen data samples or fault records.

2. The in-field detection apparatus according to claim 1 wherein the artificial neural network, ANN, stored in the local memory of said in-field detection apparatus (1) comprises a feed-forward neural network, in particular a convolutional neural network, CNN.

3. The in-field detection apparatus according to claim 1 wherein the artificial neural network, ANN, stored in the local memory of said in-field detection apparatus (1) comprises a recurrent neural network, RNN.

4. The in-field detection apparatus according to any of the preceding claims 1 to 3 wherein the fault type detected by said in-field detection apparatus (1) comprises a short circuit between power transmission lines and/or an interruption of a power transmission line.

5. The in-field detection apparatus according to any of the preceding claims 1 to 4 wherein the preprocessing unit (2) and the processing unit (3) operate in real time to detect the fault type of the fault having occurred at a power transmission line of said power supply system.

6. The in-field detection apparatus according to any of the preceding claims 1 to 5 wherein the artificial neural network, NN, executed by said processing unit (3) comprises an input layer adapted to receive the normalized measured voltage and/or current raw data from said preprocessing unit,
one or more hidden layers and
an output layer adapted to output the fault type scores evaluated to detect the fault type of the occurred fault.

7. The in-field detection apparatus according to any of the preceding claims 1 to 6 wherein the fault type scores comprise a probability that a fault of a predefined fault type has occurred.

8. The in-field detection apparatus according to any of the preceding claims 1 to 7 wherein the preprocessing unit (2) is adapted to normalize raw data of a measured fault record comprising
- voltage raw data of different voltage phases, UL, transported through corresponding power transmission lines,
- current raw data of associated electrical currents, IL, transported through the respective power transmission lines, and
- current raw data of an electrical current, IE, flowing through earth, E.

9. The in-field detection apparatus according to claim 8 wherein the voltage and/or current raw data of the measured fault record processed by said preprocessing unit (2) comprises data samples measured by corresponding sensors within a time window having a predetermined window size.

10. The in-field detection apparatus according to any of the preceding claims 1 to 9 wherein a database or an online stream of fault records with known fault types is provided and used to train the artificial neural network, ANN, stored in the local memory of said in-field detection apparatus (1).

11. The in-field detection apparatus according to claim 10 wherein the database of fault records comprises simulated fault records and/or fault records of historical faults having occurred at power transmission lines of said power supply system.

12. The in-field detection apparatus according to any of the preceding claims 1 to 11 wherein the preprocessing unit (2) is adapted to perform a Z-score or min-max normalization of measured voltage and/or current raw data of power transmission lines.

13. The in-field detection apparatus according to any of the preceding claims 1 to 12 wherein countermeasures to remove the fault are initiated automatically by a controller depending on the detected fault type.

14. The in-field detection apparatus according to any of the preceding claims 1 to 13 wherein the local memory of said in-field detection apparatus (1) has a small memory space of less than 256 Megabyte.

15. A method for automatic detection of a fault type of a fault having occurred at power transmission lines of a power supply system,
the method comprising the steps of:
(a) training (S0) an artificial intelligence module and an artificial neural network;
(b) normalizing (S1) measured voltage raw data and/or current raw data of power transmission lines;
(c) executing (S2) the artificial neural network, ANN, stored in a local memory of an in-field detection apparatus to map the normalized voltage and current raw data to fault type scores of different predefined fault types; and
(d) evaluating (S3) the fault type scores to detect the fault type of the occurred fault;
**characterized in that**
the artificial intelligence module and the artificial neural network are trained in the step of training (S0) on a combination of simulated fault records and faults comprising real data samples of historical real faults, to interpret patterns in the data to process new previously unseen data samples or fault records.

## Patentansprüche

1. Feld-Erkennungsvorrichtung (1) zum automatischen Erkennen einer Störungsart einer Störung, die bei Hochspannungsleitungen eines Stromversorgungssystems aufgetreten ist, wobei die Feld-Erkennungsvorrichtung (1) Folgendes umfasst:
a) eine Vorverarbeitungseinheit (2), die so ausgelegt ist, dass sie Rohmessdaten für eine Spannung und/oder für einen Strom in den Hochspannungsleitungen normalisiert,
b) eine Verarbeitungseinheit (3), die so konfiguriert ist, dass sie ein künstliches neuronales Netz KNN ausführt, das in einem lokalen Speicher der Feld-Erkennungsvorrichtung gespeichert ist, wobei die normalisierten Rohdaten für Spannung und/oder Strom auf Störungsartwertungen verschiedener vordefinierter Störungsarten abgebildet werden und die Störungsartwertungen von der Verarbeitungseinheit (3) beurteilt werden und so die Störungsart der aufgetretenen Störung erkannt wird,
wobei die Feld-Erkennungsvorrichtung (1) **gekennzeichnet ist durch**
c) ein Künstliche-Intelligenz-Modul, wobei das Künstliche-Intelligenz-Modul und das künstliche neuronale Netz anhand einer Kombination aus simulierten Störungsdatensätzen und Störungen, die echte Datenbeispiele aus früheren echten Störungen umfassen, zum Interpretieren von Mustern in den Daten für das Verarbeiten neuer, bisher nicht gesehener Datenbeispiele oder Störungsdatensätze trainiert werden.

2. Feld-Erkennungsvorrichtung nach Anspruch 1, wobei das in dem lokalen Speicher der Feld-Erkennungsvorrichtung (1) gespeicherte künstliche neuronale Netz KNN ein neuronales Feed-Forward-Netz, insbesondere ein faltendes neuronales Netz FNN umfasst.

3. Feld-Erkennungsvorrichtung nach Anspruch 1, wobei das in dem lokalen Speicher der Feld-Erkennungsvorrichtung (1) gespeicherte künstliche neuronale Netz KNN ein rückgekoppeltes neuronales Netz RNN umfasst.

4. Feld-Erkennungsvorrichtung nach einem der vorhergehenden Ansprüche 1 bis 3, wobei die von der Feld-Erkennungsvorrichtung (1) erkannte Störungsart einen Kurzschluss zwischen Hochspannungsleitungen und/oder eine Unterbrechung einer Hochspannungsleitung umfasst.

5. Feld-Erkennungsvorrichtung nach einem der vorhergehenden Ansprüche 1 bis 4, wobei die Vorverarbeitungseinheit (2) und die Verarbeitungseinheit (3) dazu dienen, die Störungsart für die Störung, die bei einer Hochspannungsleitung des Stromversorgungssystems aufgetreten ist, in Echtzeit zu erkennen.

6. Feld-Erkennungsvorrichtung nach einem der vorhergehenden Ansprüche 1 bis 5, wobei das von der Verarbeitungseinheit (3) ausgeführte künstliche neuronale Netz KNN eine Eingabeschicht, die so ausgelegt ist, dass sie die normalisierten Rohmessdaten für die Spannung und/oder den Strom aus der Vorverarbeitungseinheit,
ein oder mehrere verborgene Schichten und
eine Ausgabeschicht umfasst, die so ausgelegt ist, dass sie die Störungsartwertungen ausgibt, die zum Erkennen der Störungsart der aufgetretenen Störung beurteilt wurden.

7. Feld-Erkennungsvorrichtung nach einem der vorhergehenden Ansprüche 1 bis 6, wobei die Störungsartwertungen eine Wahrscheinlichkeit umfassen, dass eine Störung von einer vordefinierten Störungsart aufgetreten ist.

8. Feld-Erkennungsvorrichtung nach einem der vorhergehenden Ansprüche 1 bis 7, wobei die Vorverarbeitungseinheit (2) so ausgelegt ist, dass sie Rohdaten aus einem Störungsmessdatensatz normalisiert, der Folgendes umfasst:
- Spannungsrohdaten für verschiedene Spannungsphasen UL, die über entsprechende Hochspannungsleitungen transportiert werden,
- Stromrohdaten für zugehörige elektrische Ströme IL, die über die jeweiligen Hochspannungsleitungen transportiert werden, und
- Stromrohdaten für einen elektrischen Strom IE, der über Masse E fließt.

9. Feld-Erkennungsvorrichtung nach Anspruch 8, wobei die Spannungs- und/oder die Stromrohdaten aus dem von der Vorverarbeitungseinheit (2) verarbeiteten Störungsmessdatensatz Datenbeispiele umfassen, die von entsprechenden Sensoren innerhalb eines Zeitfensters gemessen werden, das eine vordefinierte Fenstergröße aufweist.

10. Feld-Erkennungsvorrichtung nach einem der vorhergehenden Ansprüche 1 bis 9, wobei eine Datenbank oder ein Online-Stream aus Störungsdatensätzen mit bekannten Störungsarten zur Verfügung gestellt und zum Trainieren des künstlichen neuronalen Netzes KNN benutzt wird, das im lokalen Speicher der Feld-Erkennungsvorrichtung (1) gespeichert ist.

11. Feld-Erkennungsvorrichtung nach Anspruch 10, wobei die Datenbank aus Störungsdatensätzen simulierte Störungsdatensätze und/oder Störungsdatensätze früherer Störungen umfasst, die bei Hochspannungsleitungen des Stromversorgungssystems aufgetreten sind.

12. Feld-Erkennungsvorrichtung nach einem der vorhergehenden Ansprüche 1 bis 11, wobei die Vorverarbeitungseinheit (2) so ausgelegt ist, dass sie an Rohmessdaten für die Spannung und/oder den Strom in den Hochspannungsleitungen eine z-Wert- oder Min-Max-Normalisierung durchführt.

13. Feld-Erkennungsvorrichtung nach einem der vorhergehenden Ansprüche 1 bis 12, wobei Gegenmaßnahmen zum Entfernen der Störung je nach erkannter Störungsart von einer Steuerung automatisch veranlasst werden.

14. Feld-Erkennungsvorrichtung nach einem der vorhergehenden Ansprüche 1 bis 13, wobei der lokale Speicher der Feld-Erkennungsvorrichtung (1) einen geringen Speicherplatz von weniger als 256 Megabyte besitzt.

15. Verfahren zum automatischen Erkennen einer Störungsart einer Störung, die bei Hochspannungsleitungen eines Stromversorgungssystems aufgetreten ist, wobei das Verfahren folgende Schritte umfasst:
a) Trainieren (S0) eines Künstliche-Intelligenz-Moduls und eines künstlichen neuronalen Netzes,
b) Normalisieren (S1) von Rohmessdaten für eine Spannung und/oder Rohmessdaten für einen Strom in den Hochspannungsleitungen,
c) Ausführen (S2) des künstlichen neuronalen Netzes KNN, das in einem lokalen Speicher einer Feld-Erkennungsvorrichtung gespeichert ist, zum Abbilden der normalisierten Rohdaten für Spannung und Strom auf Störungsartwertungen verschiedener vordefinierter Störungsarten und
d) Beurteilen (S3) der Störungsartwertungen zum Erkennen der Störungsart der aufgetretenen Störung,
**dadurch gekennzeichnet, dass**
das Künstliche-Intelligenz-Modul und das künstliche neuronale Netz beim Trainieren (S0) anhand einer Kombination aus simulierten Störungsdatensätzen und Störungen, die echte Datenbeispiele aus früheren echten Störungen umfassen, zum Interpretieren von Mustern in den Daten für das Verarbeiten neuer, bisher nicht gesehener Datenbeispiele oder Störungsdatensätze trainiert werden.

## Revendications

1. Appareil de détection sur le terrain (1) pour la détection automatique d'un type de défaillance d'une défaillance s'étant produite au niveau de lignes de transmission d'énergie d'un système d'alimentation en énergie,
ledit appareil de détection sur le terrain (1) comprenant :
(a) une unité de prétraitement (2) adaptée pour normaliser les données brutes de tension et/ou les données brutes de courant mesurées des lignes de transmission d'énergie ;
(b) une unité de traitement (3) configurée pour exécuter un réseau neuronal artificiel, ANN, stocké dans une mémoire locale dudit appareil de détection sur le terrain, dans lequel les données brutes de tension et/ou de courant normalisées sont mises en correspondance avec des scores de type de défaillance de différents types de défaillance prédéfinis et dans lequel les scores de type de défaillance sont évalués par ladite unité de traitement (3) pour détecter le type de défaillance de la défaillance survenue ;
dans lequel l'appareil de détection sur le terrain (1) est **caractérisé par**
(c) un module d'intelligence artificielle, dans lequel le module d'intelligence artificielle et le réseau neuronal artificiel sont formés sur une combinaison d'enregistrements de défaillances simulées et de défaillances comprenant des échantillons de données réelles de défaillances réelles historiques, afin d'interpréter des modèles dans les données pour traiter de nouveaux échantillons de données ou enregistrements de défaillances précédemment non vus.

2. Appareil de détection sur le terrain selon la revendication 1, dans lequel le réseau neuronal artificiel, ANN, stocké dans la mémoire locale dudit appareil de détection sur le terrain (1) comprend un réseau neuronal à action directe, en particulier un réseau neuronal convolutif, CNN.

3. Appareil de détection sur le terrain selon la revendication 1, dans lequel le réseau neuronal artificiel, ANN, stocké dans la mémoire locale dudit appareil de détection sur le terrain (1) comprend un réseau neuronal récurrent, RNN.

4. Appareil de détection sur le terrain selon l'une quelconque des revendications précédentes 1 à 3, dans lequel le type de défaillance détecté par ledit appareil de détection sur le terrain (1) comprend un court-circuit entre des lignes de transmission d'énergie et/ou une interruption d'une ligne de transmission d'énergie.

5. Appareil de détection sur le terrain selon l'une quelconque des revendications précédentes 1 à 4, dans lequel l'unité de prétraitement (2) et l'unité de traitement (3) fonctionnent en temps réel pour détecter le type de défaillance de la défaillance survenue sur une ligne de transmission d'énergie dudit système d'alimentation en énergie.

6. Appareil de détection sur le terrain selon l'une quelconque des revendications précédentes 1 à 5, dans lequel le réseau neuronal artificiel, NN, exécuté par ladite unité de traitement (3) comprend une couche d'entrée adaptée pour recevoir les données brutes de tension et/ou de courant mesurées normalisées provenant de ladite unité de prétraitement,
une ou plusieurs couches cachées et une couche de sortie adaptée pour sortir les scores de type de défaillance évalués pour détecter le type de défaillance de la défaillance survenue.

7. Appareil de détection sur le terrain selon l'une quelconque des revendications précédentes 1 à 6, dans lequel les scores de type de défaillance comprennent une probabilité qu'une défaillance d'un type de défaillance prédéfini se soit produite.

8. Appareil de détection sur le terrain selon l'une quelconque des revendications précédentes 1 à 7, dans lequel l'unité de prétraitement (2) est adaptée pour normaliser les données brutes d'un enregistrement de défaillance mesuré comprenant
- des données brutes de tension des différentes phases de tension, UL, transportées par les lignes de transmission d'énergie correspondantes,
- des données brutes de courant des courants électriques associés, IL, transportés par les lignes de transmission d'énergie respectives, et
- des données brutes du courant d'un courant électrique, IE, circulant à travers la terre, E.

9. Appareil de détection sur le terrain selon la revendication 8, dans lequel les données brutes de tension et/ou de courant de l'enregistrement de défaillance mesuré traitées par ladite unité de prétraitement (2) comprend des échantillons de données mesurés par des capteurs correspondants dans une fenêtre de temps ayant une taille de fenêtre prédéterminée.

10. Appareil de détection sur le terrain selon l'une quelconque des revendications précédentes 1 à 9, dans lequel une base de données ou un flux en ligne d'enregistrements de défaillances avec des types de défaillances connus est fournie et utilisée pour entraîner le réseau neuronal artificiel, ANN, stocké dans la mémoire locale dudit appareil de détection sur le terrain (1).

11. Appareil de détection sur le terrain selon la revendication 10, dans lequel la base de données d'enregistrements de défaillances comprend des enregistrements de défaillance simulée et/ou des enregistrements de défaillance de défaillances historiques s'étant produites sur des lignes de transmission d'énergie dudit système d'alimentation en énergie.

12. Appareil de détection sur le terrain selon l'une quelconque des revendications précédentes 1 à 11, dans lequel l'unité de prétraitement (2) est adaptée pour effectuer une normalisation Z-score ou min-max des données brutes de tension et/ou de courant mesurées des lignes de transmission d'énergie.

13. Appareil de détection sur le terrain selon l'une quelconque des revendications précédentes 1 à 12, dans lequel des contremesures pour supprimer la défaillance sont initiées automatiquement par un contrôleur en fonction du type de défaillance détecté.

14. Appareil de détection sur le terrain selon l'une quelconque des revendications précédentes 1 à 13, dans lequel la mémoire locale dudit appareil de détection sur le terrain (1) a un petit espace mémoire inférieur à 256 mégaoctets.

15. Procédé de détection automatique d'un type de défaillance d'une défaillance s'étant produite au niveau des lignes de transmission d'énergie d'un système d'alimentation en énergie,
le procédé comprenant les étapes de :
(a) entraînement (S0) d'un module d'intelligence artificielle et d'un réseau neuronal artificiel ;
(b) normalisation (S1) des données brutes de tension et/ou des données brutes de courant mesurées des lignes de transmission d'énergie ;
(c) exécution (S2) du réseau neuronal artificiel, ANN, stocké dans une mémoire locale d'un appareil de détection sur le terrain pour mettre en correspondance les données brutes de tension et de courant normalisées avec des scores de type de défaillance de différents types de défaillances prédéfinis ; et
(d) évaluation (S3) des scores de type de défaillance pour détecter le type de défaillance de la défaillance survenue ;
**caractérisé en ce que** le module d'intelligence artificielle et le réseau neuronal artificiel sont entraînés dans l'étape d'entraînement (S0) sur une combinaison d'enregistrements de défaillances simulées et de défaillances comprenant des échantillons de données réelles de défaillances réelles historiques, afin d'interpréter des modèles dans les données pour traiter de nouveaux échantillons de données ou enregistrements de défaillances précédemment non vues.
